(19) **Europäisches Patentamt**

**European Patent Office**

**Office européen des brevets**

(11) **EP 1 079 417 A2**

(12) **EUROPEAN PATENT APPLICATION**

(43) Date of publication:
**28.02.2001 Bulletin 2001/09**

(51) Int. Cl.$^7$: **H01L 21/00**

(21) Application number: **00118468.8**

(22) Date of filing: **25.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **25.08.1999 JP 23890399**
         **21.12.1999 JP 36278999**

(71) Applicant: **Komatsu Ltd**
**Minato-ku, Tokyo 107-8414 (JP)**

(72) Inventor: **Sato, Etsuro**
**Kanagawa ken (JP)**

(74) Representative:
**Stenger, Watzke & Ring**
**Patentanwälte**
**Kaiser-Friedrich-Ring 70**
**40547 Düsseldorf (DE)**

(54) **Non-contact detecting apparatus for detecting flat surface area, method thereof, apparatus for measuring tilt angle of tilted flat plane, laser marker provided with the same and mark reading apparatus**

(57) The invention provides a tilted angle measuring apparatus for measuring reliably a tilted angle (θ) with a simple configuration, a laser marker and a dot mark reading apparatus provided with the tilted angle measuring apparatus. The tilted angle measuring apparatus is particularly preferable for measuring a tilted angle (θ) on a tilted flat area in a minute area. While moving a detecting surface (12b, 13b) on an orthogonal coordinate system and a bending coordinate system, a light beam with a required cross sectional area to the detecting surface (12b, 13b), the irradiated light beam is received as a reflection and the received light amount is measured. If the measured light amount exceeds a predetermined light amount to reach the maximum value, a corresponding area is detected to be a flat surface. When one of a light emitter (105a) and a light receiver (105b) is immovably secured and other one has an unchanged irradiating area but a changed incident angle (γ), the received light amount received by the light receiver (105b) is changed. By using a principle of the light amount variation, a tilted angle (θ) of the measuring surface (12b, 13b) with respect to a standard surface is measured via a calculating means.

FIG. 11

**Description**

BACKGROUND OF THE INVENTION

1. Field of the Invention:

The present invention relates to a detection of a minute flat plane. The present invention particularly relates to a non contact detecting apparatus for detecting a flat surface area with a simple detecting mechanism precisely and promptly, a method thereof, an apparatus for measuring a tilt angle of a flat tilted face, which is tilted with an arbitrary tilt angle, a laser marker with the measuring apparatus and a mark reading apparatus for a semiconductor wafer.

2. Description of the Related Art:

Conventionally, many positioning apparatuses for positioning a wafer to a predetermined position have been suggested in an exposure transcription step or the like with respect to the wafer in a semiconductor element manufacturing apparatus. Recently, a positioning apparatus with accuracy and a high speed is suggested. For example, Japanese Laid Open Patent Publication No. 4-212436 and Japanese Laid Open Patent Publication No. 6-45226 disclose such an apparatus.

The Japanese Laid Open Patent Publication No. 4-212436 discloses an apparatus for positioning a circular substrate provided with a cut portion in a predetermined shape, which is mounted on a rectangular coordinate system. In this apparatus, a direct action stage movable in a two dimension within a rectangular coordinate system is mounted on a first rotation stage, which is slightly rotatable about an origin of the rectangular coordinate system as an approximate rotational center. Further, a second rotation stage is mounted on the direct action stage. The second stage can rotate at least one time, holding the circular substrate. During rotation of the second rotation stage, a first non contact detector detects the information representing a change in a displacement amount from the rotational center of a peripheral portion of the circular substrate without contact. A first positioning control means controls a stop of a rotation of the second rotation stage on the basis of the detected information such that the cut portion of the circular substrate is set in a predetermined direction on the rectangular coordinate system.

On the other hand, a second non contact detector can detect positions of at least three points on a peripheral portion of the circular substrate without contact. The second non contact detector has detecting points on at least predetermined three points within the rectangular coordinate system. After the first positioning control means sets the cut portion in a predetermined direction, a second positioning control means controls the direct action stage and the first rotation stage on the basis of the detection information on at least three detecting points of the second detector. Thereby, the center of the circular substrate is positioned, keeping an approximately certain relation with the origin of the rectangular coordinate system, while a remaining rotation error of the circular substrate with respect to rectangular coordinate system becomes approximately zero.

According to the Japanese Laid Open Patent Publication No. 6-45226, a wafer having a cut portion on a part of a circumference is mounted on a drivable substrate and the wafer is positioned by using signals from three detecting units having a light emitting element and a light receiving element, respectively. The light receiving elements in the three detecting units comprise a linear image sensor, respectively, and the linear image sensor of the first detecting unit is set in a direction of a tangential line of the wafer. Further, the linear image sensors of the second and the third detecting units are set in a radial direction of the wafer. Driving means drives the substrate and positions the wafer by using the output signals from respective detecting units.

According to such a simple constitution, particularly by configuring the three light receiving elements with linear image sensors, reading by the light receiving elements for positioning the end portion of the wafer from the outside into the inside and scanning from the center of the light receiving elements to right and left and obtaining a falling edge by the light receiving elements for positioning a notch portion position, it is possible to position the substrate such as a wafer or the like to a predetermined position with a high accuracy and a high speed not depending on that the wafer is transparent or not and the wafer has a scratch on its outer peripheral. Further, there is an effect such that the edge detecting time is shortened and the prealignment time is also shortened since s starting pixel of the fall edge detecting scan is not fixed and the notch portion is detected from the previous starting pixel upon roughly detecting the notch portion.

In the meantime, conventional positioning apparatuses including positioning apparatuses of a wafer disclosed in the above publications detect a standard mark position such as an orientation flat and a V notch portion or the like, which are configured on the circumference of the wafer. The conventional positioning apparatuses move the wafer to correct it in the three axis directions and position the wafer so that the detecting position corresponds to a predetermined set position for positioning.

On the other hand, various historical information such as a processing record in the wafer manufacturing step or semiconductor manufacturing step and a historical feature for every lot are represented by a dot mark on, for example, a front surface of the orientation flat of the wafer and the rear surface of the wafer. Further, recently, the applicant of the present invention previously suggested in Japanese Patent Application No. 10-334009 that a minute dot mark with a length of 0.01 - 5 μm and the maximum width of 1 - 15 μm could be manufactured as the above mentioned dot mark. This dot mark also excels in visual recognition. Accordingly, the area marked by this dot mark is enlarged remarkably. For example, there has been a minute area marked by the dot mark, such as a scribe line being a cutting line area to cut a wafer in a size of a semiconductor chip, a chamfer of the wafer peripheral portion and a flat chamfer of a V notch portion as a standard mark for positioning in the wafer peripheral portion.

When the wafer is set to be horizontal upon marking, since the orientation flat portion and the scribing line are configured with a horizontal surface, it is not so difficult technically to orthogonalize an optical axis to a beam irradiating face upon positioning for marking by irradiating a laser beam. However, since a tilt angle of the chamfer is not always constant, for example, in the wafer peripheral portion and the chamfer of a V notch portion, it is necessary for the tilt angle to be recognized reliably for every marking in order to orthogonalize the optical axis to the flat surface of the chamfer.

The above necessity is not observed until the above minute dot mark with an excellent visual recognition is realized. As a result, although various arts are developed to detect the orientation flat of the wafer and the V notch portion as a standard mark for positioning as described above, there has been no art that can detect a minute part and a tilt angle of a tilted face of a chamfer as a minute area of the wafer peripheral portion and the V notch portion.

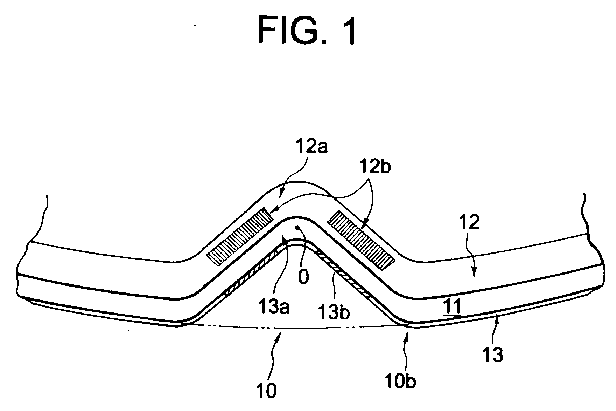

FIG. 1 shows a V shaped notch portion 10 defined on a peripheral portion of a semiconductor wafer W. Insides of the wafer peripheral portion and the V shaped notch portion 10 are chamfered along ridge lines of a front and a back side of the wafer, respectively so that chamfer areas 12 and 13 are defined upward and downward with interposing a central vertical surface area 11 therebetween. An inward bottom portion 10a and an inlet corner portion 10b of the V shaped notch portion 10 continue to an adjacent side via a rounded portion, respectively. An inner flexural angle of the central inward bottom portion 10a is approximately $90^{\circ}$ and a length on the radius, from the central inward bottom portion 10a to the wafer peripheral portion is about 1 mm. Further, chamfer angles in the upper and lower chamfer areas 12 and 13 are between $20^{\circ}$ through $30^{\circ}$.

Accordingly, after the upper and lower chamfer areas 12 and 13 of the V shaped notch portion are caved in from the circumference surface of the wafer W to its inside linearly via the rounded portion, they are cut out to the outside linearly via the rounded portion again to continue to the circumference surface of the wafer W via the rounded portion. Therefore, the upper and lower chamfer areas 12 and 13 of the V shaped notch portion 10 have flat surfaces 12b and 13b on both sides of truncated cone faces 12a and 13a. The flat surfaces 12b and 13b are provided with a minute dot mark such that the length is 0.01 - 5 μm and the maximum width is 1 - 15 μm; the central portions thereof protrude from the flat surfaces 12b and 13b by the dot marking method disclosed in the Japanese Patent Application No. 10-334009 by the applicant of the present invention.

In the case of generating such a minute dot mark, it is necessary for the tilt angle of the flat surfaces 12a and 13a to be recognized reliably in order to orthogonalize optical axis OA of a laser marker to the flat surfaces 12b and 13b of the chamfer areas 12 and 13 as described above. Such a minute dot mark with an excellent visual recognition is realized for the first time by the above Patent Application. As a result, although various arts are developed to detect the orientation flat of the wafer and the V notch portion as a standard mark for positioning as described above, there has been no art that can detect a tilt angle of a tilted face of a chamfer as a minute area of the wafer peripheral portion and the V notch portion as described above.

SUMMARY OF THE INVENTION

The present invention has been made taking the foregoing problems into consideration, a first object of which is to provide a non contact detecting apparatus that can detect a minute and a local flat surface area with a simple detecting mechanism precisely and promptly and a method thereof. A second object of the present invention is to provide a non contact detecting apparatus for positioning various processing machines for the flat surface at the same time as the above detection of the flat surface and a method thereof.

Further, a third object of the present invention is to provide an apparatus for measuring a tilt angle of a flat tilted face in a minute area with a simple detecting mechanism precisely and promptly, a laser marker and a dot mark reading apparatus provided with it.

A non contact detecting apparatus for detecting a flat surface area of the present invention comprises irradiating means for irradiating a light beam having a required cross sectional area on a surface to be detected, light receiving means for receiving a reflection of the irradiated light beam, measuring means for measuring received light variation of the reflection and maximum light amount area detecting means for detecting the maximum light amount area, in which the measured light amount exceeds a predetermined light amount.

The present invention utilizes an optical feature effectively. For example, an optical detector comprising a light emitter and a light receiver is used in the present invention. In the optical detector, a light emitting axis is directed to an arbitrary spot in a surface area to be detected. Further, the light received is set secured or movable such that a receiving axis is directed to cross the light emitting axis with a desirable crossing angle in the above spot. It is preferable that at the same time, the laser marker is set in advance such that a processing axis of the processing machine or the like, for example, an optical irradiating axis of the laser marker is mounted on a bisector which passes through an intersecting point of the light emitting axis and the light receiving axis.

At this time, on the assumption that the surface to be detected comprises a flat surface, an irradiating light from the light emitter is reflected on the above spot so that the light receiver receives 100 % of the reflection. On the other hand, if the surface to be detected has irregularities, or the surface to be detected crosses the optical irradiating axis of the laser marker not with right angle but with a certain angle even when it comprises a flat surface, the irradiation light from the light emitter is reflected diffusely on the spot or the light receiver does not receive the reflection at all or receives the reflection slightly since the light receiver is not located with respect to the light emitter so as to obtain a mirror reflection.

According to the present invention, a light amount measuring means measures the amount of the received light, which is received by the light receiver. Further, means for detecting the maximum light amount area detects an area that the measured light amount exceeds a predetermined light amount and reaches the maximum light amount area. This detection allows a precise processing to be obtained by setting, for example, a processing axis of various processing machines or the like on a normal line of the flat surface area.

A non contact detecting apparatus of the present invention further comprises moving means for moving the surface to be detected. The moving means comprises moving means for moving the surface to be detected to at least one direction among three axial directions of three axial coordinate system, in which a predetermined point of the surface to be detected is an origin, and rotational direction about the bending coordinate axis.

For example, in the case that the surface to be detected has a certain area of flat surface, when the surface to be detected is moved in three axial direction, particularly, the x axial direction and the y axial direction within a horizontal surface, the received light amount is kept to be its maximum value in a certain moving area. During the maximum value of the received light amount is kept, the irradiating area is a flat surface area. When the surface to be detected rotates about the flexure coordinating axis, the flat surface can be detected from the three axes so that the flat surface can be detected reliably. In fact, considering complexity or a large size of the mechanism, the flexural coordinate axis does not rotate about all three axes, but it often rotates about two arbitrary axes. From the view of detection, rotation about two axes is enough.

The surface to be detected is moved in at least one axial direction of the tree axial directions, i.e., x y and z axial directions, or it is moved in various directions including rotation about $\phi$ axis in addition to the above three axes. On this movement, the spot is inevitably displaced. Under such a condition, irradiating the light from the light emitter to the spot makes the light incident angle changed due to the movement of the surface to be detected. Even when the spot comprises a flat surface, the receiver does not receive the reflection, if the light receiving axis of the receiver is not located so as to obtain a mirror reflection. Therefore, the light amount received by the receiver increases as the light receiving axis approaches to the position for mirror reflection and the maximum light received amount is obtained when the light receiving axis reaches the position for mirror reflection. Further, as the light receiving axis draws apart from the position for mirror reflection, the light received amount decreases and finally approaches to zero.

Accordingly, when the surface to be detected is moved or rotated in the various directions and the light receiving means perceives the maximum light receiving amount, the surface to be detected is a flat surface and a bisector of the light emitting axis and the light receiving axis becomes a normal line to the irradiating surface. Therefore, a processing axis of various processing machines such as a laser marker may be set on the normal line of the irradiating surface. In practice, a minute adjustment is further added to a processing surface, which is positioned in this way, and finally the processing surface is positioned so as to be precisely orthogonal to the processing axis.

A non contact detecting apparatus according to the present invention preferably comprises moving means for moving one or both of the irradiating means and the receiving means. In the above described embodiment, the irradiating means and the light receiving means are fixed and the surface to be detected is moved in various directions so that the flat surface is opposed to the processing machines or the like. However, in the present embodiment, the surface to be detected is fixed and the irradiating means and the light receiving means are moved to detect the flat surface. The detection principle in this state has no alteration.

A detecting method of a flat surface according to the present invention includes irradiating a light having a predetermined area on the surface to be detected, receiving reflection of the irradiated light, measuring amount of change in the received light and detecting the maximum light amount area that the measured light amount exceeds a predetermined light amount.

If the surface to be measured is flat, a parallel light to be irradiated to the surface to be detected at a certain incident angle is reflected with the same angle as the incident angle in all irradiation. Therefore, one of a light emitter and a light receiver is fixed to be immobile and in the other one of them, an irradiating area remains unchanged but the incident angle thereof is changed, so that a light amount received by the light receiver is changed. By using this principle of change in optical amount, a tilted angle of the surface to be detected with respect to a standard surface is measured through a calculating means.

In other words, the invention also includes a tilted angle measuring apparatus for measuring a tilted angle of a tilted flat surface, which comprises an optical system having a light emitter for irradiating a tilted flat surface as a surface to be detected, and a light received for receiving the reflection on said tilted flat surface, incident angle changing means for relatively changing an incident angle of an optical axis of said light emitter to the surface to be detected, incident angle detecting means for detecting the incident angle when the receiving light by the light receiver is at it's maximum while said incident angle is changing and calculating means for calculating a tilted angle of the tilted flat surface from the incident angle at the maximum receiving light detected by the incident angle detecting means.

According to the present invention, means for relatively changing the incident angle changes the incident angle in following two manners. In one case, one of the light emitter or the light receiver is fixed to be immobile and in the other one, an irradiating area remains unchanged but the incident angle thereof is changed. In other case, the light emitter and the light receiver are secured to be immobile and an irradiating area remains unchanged but the surface to be detected thereof is moved.

The means for changing the incident angle has a rotational driving system. The rotational driving system rotates the surface to be detected around the line on the surface to be detected, which passes through an intersecting point of the optical axis of the light emitter and the surface to be detected. In this invention, the means for relatively changing the incident angle takes the embodiment such that the light emitter and the light receiver are secured to be immobile and the irradiating area remains unchanged but the surface to be detected thereof is moved.

For example, in the case that various processing devices, which works with the means for measuring a tilted surface, are provided around the surface to be detected in addition to the light emitter and the light receiver, it is preferable that the means for changing the incident angle changes the incident angle in the condition that the light emitter and the light receiver are fixed to be immobile as the present embodiment in order to prevent mutual intervention among the above devices as much as possible.

The means for changing the incident angle has another rotational driving system. This rotational driving system rotates the light emitter within a plane including the light emitter and the light receiver without changing the intersecting point of the optical axis of the light emitter and the surface to be detected. In this invention, the means for relatively changing the incident angle takes the embodiment such that the light emitter is fixed to be immobile and the light emitter is moved. This embodiment is advantageous in the case, for example, the tilted angle on the surface to be detected is measured by a measure by itself and the measured tilted angle is recorded in a controller or the like and following processing steps are subjected to the measured tilted angle.

The above described non contact detecting apparatus and tilted angle measuring apparatus are preferably applied to the laser marker for generating a dot mark on the flat surface of the V notch portion of the semiconductor wafer by irradiation of a laser beam.

With these devices, a sufficient result in detecting and measuring a minute area such as a flat chamfer surface of the V notch portion, which is defined on the peripheral portion of the semiconductor wafer, can be obtained since these devices can detect and measure with a high accuracy in spite of its simple configuration and operation. On the other hand, the dot mark to be defined on the flat chamfer surface by the laser marker also has a minute figuration. In order to define the dot mark with such a minute figuration, it is necessary for an optical axis of the laser marker to be reliably orthogonal to the flat surface. From this point, it is preferable that the tilted angle of the flat surface as the foregoing minute area is measured with a high accuracy by the measuring devices while the laser marker is positioned so as to reliably orthogonalize the optical axis of the laser marker to the flat surface.

Further, the non contact detecting apparatus and the tilted surface measuring apparatus on the flat surface may be employed for the dot mark reading apparatus to read the minute dot mark, which has been already defined on the flat chamfer surface of the V notch portion as the minute area. The above dot mark reading apparatus is advantageous in that, unlike the above described arrangement of the laser marker, extremely accurate positioning is not required and various arrangements are possible. It is not so difficult to find the area in which a dot mark is applied because the area comprises the flat chamfer surface of the V notch portion of the semiconductor wafer and the flat chamfer surface thereof is already applied with the minute figurate dot mark. However, it is very difficult to read the area crossly because an optical Image of the dot mark is deformed. On this account, incorporating the tilted surface measuring apparatus in the reading apparatus allows the optical image of the dot mark not to be deformed so as to read it reliably.

BRIEF DESCRIPTION OF THE DRAWINGS

FIG. 1 shows an enlarged perspective view of a V notch portion of a semiconductor wafer W showing an example of an object to be measured by a tilted angle measuring apparatus according to the present invention.
FIG. 2 is a schematic view of a laser marker to define a minute dot mark.
FIG. 3 is a side view showing schematically an arrangement of a laser marker provided with a non contact detecting apparatus of a flat surface area according to a first embodiment of the present invention.
FIG. 4 is a plan view of the non contact detecting apparatus in FIG. 3.
FIG. 5 illustrates main portions showing a rotational direction and a tilt rotational direction of a wafer by the non contact detecting apparatus and positions of a light emitter and a light receiver.
FIG. 6 is a typical view illustrating a detecting principle of a flat surface according to the present invention.
FIG. 7 is a detection line diagram showing change of an amount of a received light on the basis of an incident angle variance of a light emitter according to the present invention.
FIGS. 8A and 8B illustrate a level variance of an optical electric signal to be transmitted from a detector of the present invention.
FIG. 9 is a block diagram showing a schematic arrangement of a dot mark reading apparatus incorporated with the flat surface detecting apparatus according to a second embodiment of the present invention.
FIG. 10 is a flow chart showing a reading procedure of the dot mark by the mark reading apparatus.
FIG. 11 is a schematic view showing a laser marker provided with a tilted angle measuring apparatus according to a third embodiment of the present invention.
FIGS. 12A and 12B are an AFM observed cross section and stereoscopic view showing an optical image obtained by picturizing a minute dot mark with a protruded central portion by the dot mark reading apparatus from a diagonally upper direction.
FIGS. 13A and 13B are an AFM observed cross section and stereoscopic view showing another optical image obtained in the same way as FIGS. 12A and 12B.
FIGS. 14A and 14B are an AFM observed cross section and stereoscopic view showing an optical image obtained by picturizing a minute dot mark with a fallen central portion by the dot mark reading apparatus from a diagonally upper direction.

DESCRIPTION OF THE PREFERRED EMBODIMENTS

FIG. 1 shows an enlarged perspective view of a V notch portion of a semiconductor wafer W showing an example of an object to be measured by a non contact detecting apparatus and a tilted angle measuring apparatus according to the present invention.

Usually, an unillustrated orientation flat that is defined by linearly cutting a part of a peripheral portion of the semiconductor wafer W and a V notch portion 10 that is defined by cutting the peripheral portion of the semiconductor wafer W in a V shape are defined on a peripheral portion of the semiconductor wafer W. The insides of the wafer W's peripheral portion and the V shaped notch portion 10 are chamfered along ridge lines of a front and a back side of the wafer, respectively. Chamfer areas 12 and 13 are defined upward and downward with interposing a central vertical surface area 11 therebetween. A central inward bottom portion 10a and an inlet corner portion 10b of the V shaped notch portion 10 continue to an adjacent side via a rounded portion, respectively. An inner flexural angle of the central inward bottom portion 10a is approximately $90^\circ$ and a length on the radius, from the central inward bottom portion 10a to the wafer peripheral portion is about 1 mm. Further, chamfer angles in the upper chamfer area 12 and the lower chamfer area 13 are between $20^\circ$ through $30^\circ$.

Accordingly, the upper chamfer area 12 and the lower chamfer area 13 of the V shaped notch portion 10 are caved in from the circumference surface of the wafer W to the inside linearly via the rounded portion after they are cut out to the outside linearly via the rounded portion again to continue to the circumference surface of the wafer W via the rounded portion. Therefore, the upper chamfer area 12 of the V shaped notch portion 10 has flat surfaces 12b on both sides with interposing an inverse truncated cone face 12a. The flat surface 12b is provided with a minute dot mark such that the length is 0.01 - 5 $\mu$m and the maximum width is 1 - 15 $\mu$m as disclosed in the Japanese Patent Application No. 10-334009 by the applicant of the present invention.

Further, a silicon wafer itself is typically used as a material of the above mentioned semiconductor wafer. Other than this, a wafer that $SiO_2$ membrane and SIN membrane are applied on its surface, a wafer with an epitaxial growth and a wafer that gallium arsenide and indium phosphide are applied on its surface may be included as a material of the above mentioned semiconductor wafer.

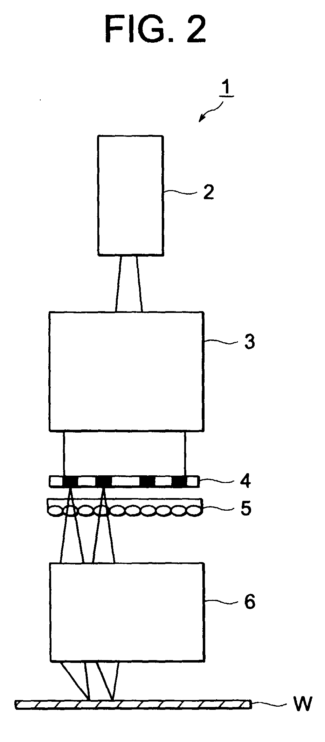

With reference to FIG. 2, a method for manufacturing the above mentioned dot mark is explained below. A laser beam, which is emitted from a laser oscillator 2 of a laser marker 1 and has a gaussian shaped energy density distribution, is formed in a top hut shaped energy density distribution having approximately even apex tops, via a beam homogenizer 3, in which, for example, a fly eye lens, a binary optics and a cylindrical lens are used. Then, the laser beam having an even energy distribution is irradiated to a surface of a liquid crystal mask 4. At this time, the liquid crystal mask 4 is capable of drivably indicating a required marking pattern on the mask as been widely known. The laser beam is transparent through a pixel portion, which is in an optically transparentable state within the pattern indicating area. The energy density distribution of the transparent laser beam, which is divided for every pixel to be transparent through the pixel, has also the same shape formed by the beam homogenizer 3 and it is evenly distributed.

An area that the laser beam is irradiated once to the liquid crystal mask 4 comprises dots with dot number of 10 x 11. If the area is irradiated by the laser beam in one lump, the dot number is often not enough for the required dot mark number. Therefore, the mark patterns may be separated into several blocks to be indicated on the liquid crystal mask sequentially. Then, these separated mark patterns are switched and combined to form a whole mark pattern on the wafer surface. In this case, it is necessary that the wafer or an irradiating position is controlled to be moved when the mark pattern is imaged on the wafer surface. Various well known methods can be applied to control the movement as the above.

The laser beam in a dot unit, which is transmitted through the liquid crystal mask 4, may be irradiated to a beam profile converter 5 subsequently. This beam profile converter 5 is arranged in a matrix corresponding to respective liquid crystals of the liquid crystal mask 4 arranged in a matrix. Accordingly, the laser beam transmitted through the liquid crystal mask 4 is transmitted through the beam profile converter 5 for every pixel one on one, so that the energy density distribution, which is smoothed respectively by the beam homogenizer 3, is obtained. Then, such an energy density distribution is converted into the energy density distribution having a shape that is necessary for defining a minute dot mark having the above peculiar shape.

A lens unit 6 stops down the laser beam transmitted through the profile converter 5. Then, the stopped down laser beam is irradiated to a predetermined position of the surface of the semiconductor wafer W and the required dot marking is applied on the surface of the semiconductor wafer W. It is preferable that the maximum length in a pixel unit of the liquid crystal ranges from 50 to 2000 µm to be stopped down to 1 - 15 µm on the surface of the semiconductor wafer W by the lens unit 6. If the marking in micron unit is intended to be formed evenly on a plurality of wafer surfaces, it is necessary for the distance between a marking surface and a condenser and matching of the optical axises to be adjusted in micron unit.

With respect to detection of a focal point, the height of the focal point is measured by a co-focal point system, which is generally used in a laser microscope or the like. Then, the measured value is fed back to a minute positioning mechanism in the vertical direction of the lens to position a focal point automatically. Further, in order to match the optical axes, position optical components and adjust them, a well-known method is utilized. For example, the optical components are adjusted by a screw adjusting mechanism so as to fit them to a standard spot set in advance through a guide beam such as He-Ne laser or the like.

The beam profile converter 5 is an optical component to convert the energy density distribution, which is smoothed by the beam homogenizer 3, into the energy density distribution suitable for obtaining dots having a shape peculiar in the present invention. The beam profile converter 5 converts a profile of the energy density distribution of an incident laser beam by varying arbitrarily an optical transparent rate of a diffraction phenomena, a refraction phenomena or a laser irradiating point. As the optical component, for example, a diffraction optical element, a holographic optical element, a convexed microlens array or a liquid crystal itself may be available. They are arranged in a matrix and they may be utilized as the profile converter 5.

The laser beam transmitted through the beam profile converter 5 is stopped down by the cut-down lens unit 6. Then the stopped down laser beam is irradiated to the inside of the notch portion 10 of the semiconductor wafer W, so that a required dot marking is applied to the above inside. A conventional dot marking of this type is applied on the front surface and the back surface of the peripheral surface of the semiconductor wafer W, as described above. Since it is difficult to control a thickness of a membrane of the peripheral portion of the wafer in the marking to the above portions, for example, when the etching is not sufficient, a membrane (especially, a metal membrane) is accumulated on the dot mark little by little for every CMP processing so that reading becomes impossible. The wafer surface is shaved in an attempt to remove the membrane completely, so that the depth of the dot mark becomes shallow. As a result, reading becomes impossible. In a minute dot mark in micron unit, the above stated case is crucial.

On this account, the notch portion of the semiconductor wafer, a scribe line or the wafer peripheral portion are not part of the front surface of the wafer peripheral portion to which a membrane growth processing or a membrane removing processing or the like, which affect on visual recognition, is applied positively. Therefore, it is desirable that the dot making is applied on the inside of the notch portion, the chamfer portion of the wafer peripheral portion or a front surface of a scribe line. However, a required dot number cannot be formed on these marking areas with a conventional dot size. Therefore, as described above, a minute dot marking in micro unit is required.

On the other hand, it is found that the size of respective dot of the dot mark depends on the wave length of the light source to be processed. Generally, a resolution of patterning and a processing focal point depth are represented by the following expressions.

$$\text{resolution of patterning} = Kl \cdot \lambda/NA, \text{ processing}$$

$$\text{focal point depth (width of processable focal point directional distance)} = kl \cdot \lambda/(NA)^2$$

where, k means a process factor (a proportional constant), $\lambda$ means a light source wave length and NA means a light emitting angle to the work surface.

From the above expressions, in order to make the resolution of patterning smaller, there may be decreasing of the light source wave length or enlarging of a light emitting angle to the work. However, the light emittance angle to the work is limited to a certain value due to the relation with the focal point depth. Accordingly, in the present invention, it is preferable to use a laser beam with a short wave length. Conventionally, as a light source for marking on the wafer, a standard wave of YAG laser (wave length: 1064 nm) is mainly used. However, in the present invention, a twofold wave of YAG laser (wave length: 532 nm), a threefold wave (355 nm) or a laser beam source of a wave length which is suitable for the wave length range may be used.

Thus, as a minute dot marking is realized, the focal point depth is decreased. On the other hand, when the marking is applied on the semiconductor wafer surface, influences by an error in thickness of the wafer, bowing of the wafer itself, undulation of the wafer itself and inaccuracy for positioning in wafer handling or the like are more serious than the influence of the focal point depth. As a result, means for automatically positioning focal point is indispensable in order to detect the position of the focal point and position it automatically. As a detecting means of the focal point position, as described above, a detecting method by using a general co-focal point system microscope and a trigonometrical survey are available. However, considering downsizing of an apparatus and measuring accuracy, the co-focal point system is most preferable. The function for automatically positioning a focal point is realized by a minute positioning with a feed back signal from the focal point positioning detecting means.

In the meantime, in order to assure the accuracy of this minute positioning and to obtain an ideal dot marking, it mainly depends on whether the optical axis of the laser beam reliably are orthogonal to the marking area or not.

On the other hand, as described above, the dot mark is formed on the flat surfaces 12b and 13b in the chamfer portion of the V notch portion 10 of the wafer W. The flat surfaces 12b, 13b are tilted with a required angle to the wafer surface as described above. Further, this tilted surface is not always configured with a constant tilted angle. Accordingly, in order to orthogonal the optical axis OA of the laser beam to the flat surfaces 12b, 13b, at first, it is initially necessary that the flat surfaces 12b and 13b are detected. Further, it is necessary to know precisely what angle the flat surfaces 12b, 13b have as a tilted angle $\theta$ to the wafer surface.

However, for example, with respect to the dot marking by the laser beam, it is necessary to set a light emitting portion of the laser marker close and opposing to the flat surfaces 12b and 13b. In the present embodiment, the detecting apparatus for detecting the flat surfaces 12b and 13b and/or the tilted angle measuring apparatus for measuring the tilted angle are to be set with close to the flat surfaces 12b and 13b. Therefore, it is preferable that these apparatuses are not moved from their positions as much as possible except for a minute adjustment, so as to prevent intervention each other.

Therefore, according to the present embodiment, the wafer W as the object to be measured and the object to be marked is to be moved so that there should be no need for moving the laser marker 1 and the detecting apparatus for detecting the flat surface or the apparatus for measuring the tilted angle according to the present invention to a large extent. When there is no possibility of interference between the detecting apparatus for detecting the flat surface or the apparatus for measuring the tilted angle according to the present invention and other apparatuses, a light receiver or a light emitter of these apparatuses may not be moved and the relative incident angle $\theta$ to the flat surfaces 12a and 13b may be changed.

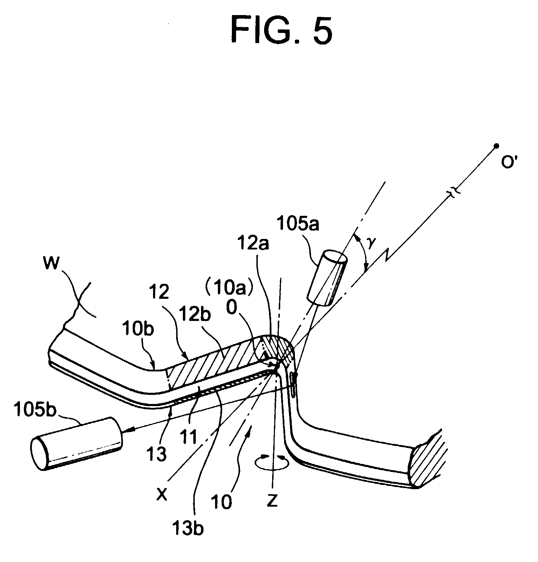

According to the present embodiment, as shown in FIG. 5, a light emitter 105a and a light electric detector 105b as a light receiver of a detector 105 at the flat surface area are arranged as follows: An optical axis of the light emitter 105a is directed from the front, diagonally upward direction to the flat surface 12b of the upper side chamfer are 12 of the V notch portion 10 and the light electric detector 105b is directed to a reflection optical axis of the flat surface 12b of a spot light to be irradiated from the light emitter 105a. Due to arranging the light emitter 105a and the light electric detector 105b as described above, there is no need for the detector 105 to approach the surface of the wafer W. The detector 105 is always arranged outside of the peripheral portion of the wafer W, so that there is no possibility that the detector 105 and the wafer W interfere each other on detecting at positioning.

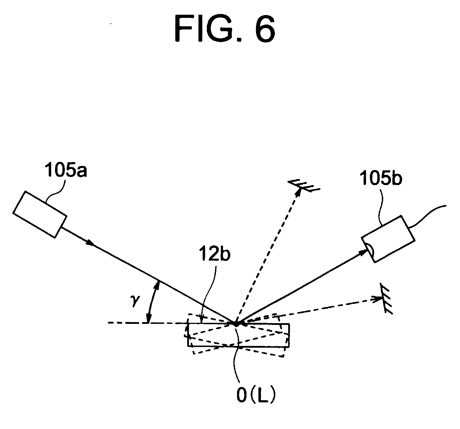

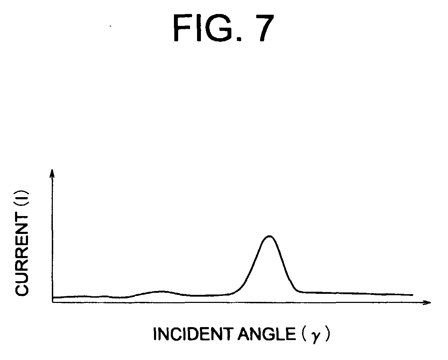

FIG. 6 is an explanatory view schematically illustrating a detecting principle by the detector 105. The light beam emitted from the light emitter 105a is radiated to the marking area of the flat surface 12b. Then, the light beam is reflected and is received by the light receiver 105b. On the assumption that the light emitter 105a and the light receiver 105b are immobilized, only the flat surface 12b is rotated around a line L that passes through the intersecting points of respective optical axes of the light emitter 105a and the light receiver 105b and is orthogonal to a flat surface including respective optical axes, the amount of the light received by the light receiver 105b increases gradually in a certain area as the rotational angle of the flat surface 12b increases as shown in FIG. 7. Finally, the amount of the received light of the light receiver 105b reaches a peak, then decreases gradually.

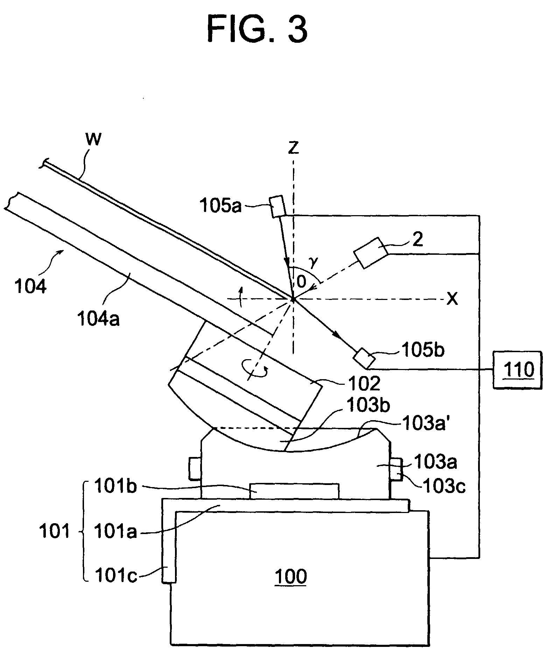

FIG. 3 shows a first embodiment as a typical example of a laser marker of the invention provided with a non contact detecting apparatus for a flat surface. In FIG. 3, a bed 100 is provided with a direct action stage 101 of a three dimensional coordinate system and a rotational table 102 provided with a tilting mechanism 103 is rotatably and controllably mounted on the direct action stage 101. Further, a wafer holding member 104 is secured on an upper surface of the rotational table 102.

A reference numeral 105 denotes a detector for detecting the flat surface area according to the invention and is provided with the light emitter 105a generating a parallel light flax for irradiating to the upper side of a chamfer portion of the V notch portion 10 with a minute spot and the optical electric detector 105b which is the light receiver to be arranged on the reflection optical axis. The detector 105 receives a signal from a main controlling unit 110 and is arranged controllably and movably on a line directed upward and downward and to a detecting point of the V notch portion 10.

The direct action stage 101 comprises an x axial direction direct action stage 101a, a y axial direction direct action stage 101b and a z axial direction direct action stage 101c. The direct action stage 101 controllably moves to the x and y flat surface coordinate axis directions along a guide surface inside of the bed 100 and also controllably moves upwardly and downwardly along the vertical axis, i.e., the z axial direction to locate the rotational table 102 provided with the tilted angle mechanism 103 to an arbitrary position by controllably moving it in the x, y and z axial directions. Control operations of the direct action stage 101, the rotational table 102 and the tilted angle mechanism 103 are carried out according to an instruction signal from the main controlling unit 110 as well as the control operation of a normal machine tool.

The tilting mechanism 103 is secured on the upper surface of the direct action stage 101. The tilting mechanism 103 is provided with a fix pedestal 103a and a rotational pedestal 103b. A guide groove 103a' in an arc shape, which extends in the x axial direction, is defined on a central portion of the fix pedestal 103a. Further, the rotational pedestal 103b has approximately same thickness as the groove width of the guide groove 103a' on the fix pedestal 103a. The rotational pedestal 103b has a shape such that a disc with a peripheral surface of the same arc as that of the guide groove 103a' is cut partially. The peripheral surface with an arc shape of the rotational pedestal 103b is fitted into the guide groove 103a' of the fix pedestal 103a. The rotational table 102 is supported controllably and rotatably on the upper surface of the rotational pedestal 103b.

A center O of respective curvatures in the arc surfaces of the guide groove 103a' and the rotational pedestal 103b is set on a center of the inside of the V notch portion 10, which is held by a wafer holding member 104. As a sliding mechanism of the rotational pedestal 103b on the fix pedestal 103a, for example, a transmission mechanism by biting of unillustrated screw axis which is inserted into the fix pedestal 103a and outer teeth which are defined on the peripheral surface of the rotational pedestal 103b may be used. Rotation of a dial 103c attached to the end portion of the screw axis allows the wafer W to be rotated around the inside center of the V notch portion 10 as a rotational center within a plane including the x and the z axes, so that the wafer W can be tilted with a desirable tilted angle.

Thus, the tilting mechanism 103 rotates the rotational table 102 together with the wafer holding member 104 by a desired angle to hold the wafer W within the plane at a desired tilted angle. Further, on the rotational pedestal 103b, an unillustrated driving source for controlling rotation of the rotational table 102 is equipped. For example, as the rotational driving mechanism of the rotational table 102, a well-known typical mechanism is as disclosed in Japanese Laid Open Patent Publication No. 4-212436, can be used. For example, by using a stepping motor and various servo meters as the driving source, the main controlling unit 110 controls the rotational angle of the rotational driving mechanism with a high accuracy.

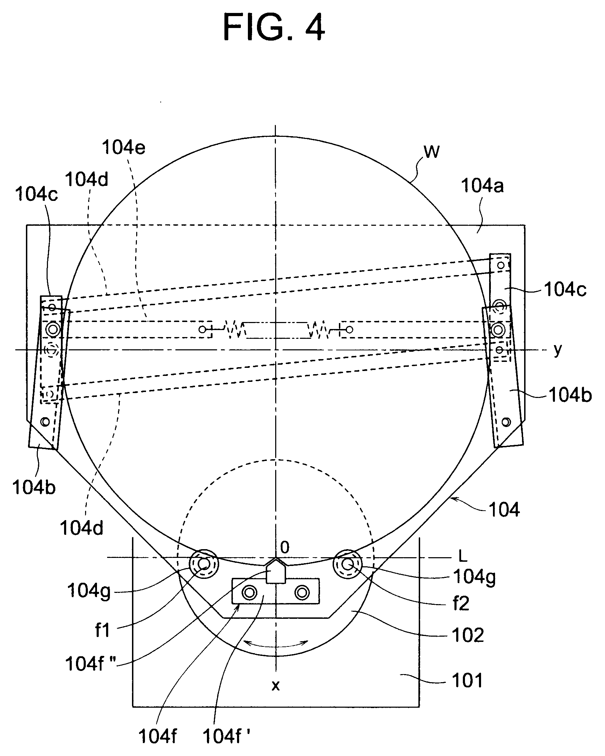

The wafer holding member 104 for holding the above wafer is secured on the upper surface of the rotational table 102. As shown in FIG. 4, the holding member 104 comprises a hexagonal base plate 104a, a pair of holding arms 104b, a pair of right and left frame members 104c, a pair of parallel connecting frame members 104d and an elastic connecting member 104e. The pair of holding arms 104b clips the wafer W at a right and a left sides with a contact point of a periphery of the wafer W and a line passing through a center O' of the wafer W located between these sides and is held rotatably at one end thereof by the base plate 104a. Respective frame members 104c are pivoted to other end of the right and left holding arms 104b with being biased from a center to the counter side and respective center portions thereof are rotatably held to the base plate 104a. The pair of parallel connecting frame members 104d rotatably connect opposite ends of respective frame members 104c. The elastic connecting member 104e connects respective pivoting points of the pair of the right and the left holding arms 104b and the pair of the right and the left frame members 104c.

The base plate 104a is secured by two points on the rotational table 102. These two fixing points f1 and f2 are positioned such that a recessed center of the V notch portion 10 defined on the wafer W corresponds to a point on the line of the rotational center of the rotational table 102 when the wafer holding member 104 is holding the wafer W.

Therefore, a positioning guide member 104f having an isosceles triangle portion, of which shape is approximately same as the shape of the V notch portion 10 is secured to a part of this base plate 104a.

The positioning guide member 104f comprises a rectangle piece 104 f' and a positioning piece 104f''. The rectangle piece 104 f' has a thickness, which is at least enough for holding the wafer W. The positioning piece 104f'' is fitted into a fitting depressed portion defined on a part of the periphery of the rectangle piece 104 f' and is slidable in the thickness direction of the rectangle piece 104f'. The positioning piece 104f'' is composed of an approximately pentagonal small piece. The positioning piece 104f'' is slidably fitted to the fitting depressed portion of the rectangle piece 104 f' in the direction of thickness so that a top of the above mentioned isosceles triangle portion is located on a midpoint of a line connecting the two fixing points f1 and f2 of the base plate 104a.

Setting of the two fixing points f1 and f2 shown in FIG. 4 is explained below. A line connecting the recessed center of the V notch portion 10 and the center O' of the wafer W is located on a bisector of a line connecting the pivot points of the right and the left holding arms 104b and the base plate 104a. Further, the recessed center of the V notch portion 10 is located so as to correspond to the rotational center O of the rotational table 102. In this arrangement, the two fixing points f1 and f2 are located on a line, which are in parallel with the line connecting the pivot points of the right and the left holding arms 104b and the base plate 104a and passes through the rotational center O of the rotational table 102, i.e., the recessed center of the V notch portion 10. Further, the two fixing points f1 and f2 are located symmetrically interposing the positioning guide member 104f of the V notch portion 10.

The rotational table 102 and the base plate 104a are fixed by pins on the two fixing points f1 and f2, respectively, and the fixed pins rotatably supports turning rollers 104g. respectively. On the peripheral surface of the turning rollers 104g, a wafer guide groove, which is a ring shape and has an approximately triangle section, is defined. When the wafer W is held on the wafer holding member 104, the outer peripheral portion is fitted with allowance into the wafer guide groove with a part of the outer peripheral surface contacting the wafer guide groove. As a result, the positioning piece 104f'' of the positioning guide member 104f is automatically fitted and engaged on the V notch portion 10 to be positioned there. In this arrangement, the bottoms of the wafer guide grooves of the turning rollers 104g are set slightly outside of the outer peripheral surface of the wafer W.

After this positioning is done, the positioning piece 104f'' is slid toward the surface of the base plate 104a within the unillustrated fitting depressed portion defined on the rectangular piece 104 f' so that fitting and engagement between the positioning piece 104f'' and the V notch portion 10 is released. In an example shown in FIG. 4, the positioning piece 104f'' is moved within the unillustrated fitting depressed portion of the rectangular piece 104 f' in the direction of thickness by a manual operation. In order to simplify the operation, it is preferable that a finger grip or the like is mounted on the surface of the positioning piece 104f''. Further, for example, a slider, which moves to and from the wafer, is equipped on the rectangular piece 104f' and the positioning piece 104f'' is always urged toward the front surface. In this state, when the slider is moved toward the wafer, the slider pushes the positioning piece 104f'' into the front surface of the base plate 104a against the urging force. On the other hand, when the slider is moved back, the positioning piece 104f'' can be automatically pushed out to the position for positioning the wafer W as being urged.

On the other hand, an irradiating lens of the laser marker 2 is set such that an irradiating optical axis OA of the laser beam is positioned on a line, which approximately orthogonals to the flat surface 12b of the upper surface chamfer area 12 formed on the V notch portion 10 of the wafer W. Further, the light emitter 105a and the light electric detector 105b of the detector 105 are set such that respective optical axes of the incident light and the reflected light crisscross toward the intersecting point area between the flat surface 12b and the irradiating optical axis OA of the laser marker 2. In this state, it is necessary that the light emitter 105a and the light electric detector 105b are positioned such that they do not interfere with the laser marker 2. According to the present embodiment, as shown in FIG. 3 and FIG. 5, the light emitter 105a is arranged diagonally upward from the flat surface 12b of the V notch portion 10 and the light electric detector 105b is arranged also diagonally upward from the flat surface 12b.

According to the present embodiment, the light beam emitted from the light emitter 105a is more than a spot light and comprises a parallel light beam having a required irradiating area. When the light amount is changing, at first, a light image received by the light electric detector 105b is a linear beam, and then, the width of the light image gradually increases and finally the light image received by the light electric detector 105b is a cross sectional shape of the light beam emitted from the light emitter 105a. At this moment, the received light amount of the light electric detector 105b becomes maximum value. Further, keeping the flat surface 12b rotating makes the width of the light image gradually decreased and finally the received light amount of the light electric detector 105b becomes minimum. If the flat surface 12b is at the rotation angle such that the received light amount of the light electric detector 105b is maximum, the light electric detector 105b receives a mirror reflection of the emitted light beam from the light electric detector 105b. As a result, a normal line on the reflection surface at that moment is detected.

When the detector 105 is set to a predetermined detecting position of a flat surface area detecting apparatus, on the basis of the instruction from the main controlling unit 110, the unillustrated driving motor for rotating a table start to operate and rotates the rotational table 102 by a required angle. Then, the light emitter 105b irradiates a spot light comprising a parallel light to the flat surface 12b of the upper surface chamfer area 12. Then, the reflected light is received by the light emitter 105b to be converted into an electric signal and to be transmitted to the main controlling unit 110.

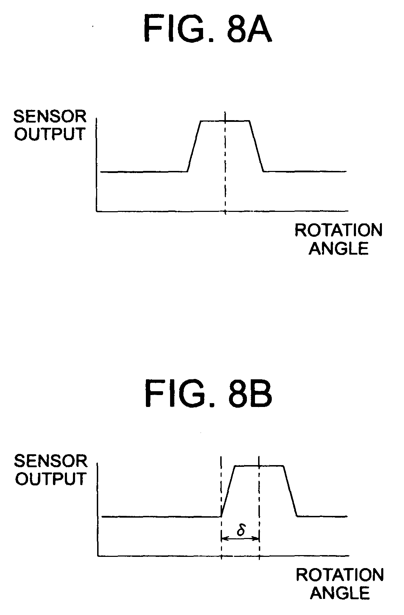

FIGS. 8A and 8B illustrate a level variation of an optical electric signal transmitted from the detector 105 of this time. FIG. 8A represents a state that a part of the flat surface 12b of the chamfer area 12 on the V notch portion 10 is located on a predetermined position, and FIG. 8B represents a state that the flat surface 12b of the V notch portion 10 is out of a predetermined position.

If the rotational table 102 rotates, the wafer W rotates together around the recessed center of the V notch portion 10. The flat surface 12b of the V notch portion 10 as a process position detecting area passes through a front surface of the detector 105. The area out of the flat surface 12b of the chamfer area 12 is slightly rounded.

When the flat surface 12b of the V notch portion 10 passes through the front surface of the detector 105, as shown in FIG. 8A, the detector 105 receives a reflection from the flat surface 12b to output the reflection as an optical electric signal. This optical electric signal gradually increases and after that it decreases. Therefore, the maximum output of the optical electric signal in FIG. 8A represents the flat surface 12b.

FIG. 8A illustrates a state that the flat surface corresponds to a predetermined standard area. In this state, a correction value to be recorded in the main controlling unit 110 is zero. On the other hand, in the output variation of an optical electric signal shown in FIG. 8B, a portion of the maximum output does not correspond to a predetermined standard area. Therefore, it is necessary to correct the wafer position by the deflection $\delta$ between the portion of the maximum output and the predetermined standard area for positioning the wafer W. The main controlling unit 110 records a correction data $\delta$.

According to the present embodiment, rotating the rotational table 102 around the recessed center O of the V notch portion 10 defined on the wafer W and rotatably moving the wafer W within the plane including x axis and y axis result in that the flat surface 12b is detected from two directions.

A light beam, of which a cross section has a certain emitting light area, is emitted by the detector 105a, then, its reflection is received. Further, on the assumption that there may be two rotational axes of the flat surface 12b as described above, respective mirror reflection areas in the two axes direction, which orthogonal to each axis, can be measured simultaneously. Accordingly, the area in which the flat surface 12b of the V notch portion 10 can be detected reliably.

In the case that the flat surface area has a large area such that it deviates from the spot area, the detecting method according to the present invention also can specify such a large area. As described above, if it is detected that the surface in a certain detecting spot is detected to be flat, rotation and tilting operation of the rotational table 102 are stopped. Further, a calculation unit of the main controlling unit 110 calculates a received light amount from the variation of the light electrical signal received by the optical electric detector 105b as the direct action stage 101 is controlled to move to three axes directions. If the calculation result is within a predetermined standard value area, a judging unit judges that the surface to be detected is a flat surface area to specify that area.

Thus, when the flat surface 12b which is a small area of the V notch portion 10 defined on the outer periphery of the wafer W is detected accurately as rotating the wafer W around the two axes about the recessed center of the V notch portion, a bisector on the intersecting point including respective optical axes of the light emitter 105a and the optical electric detector 105b in the detected area becomes a normal line to the flat surface 12b. On this normal line, the irradiated optical axis OA of the laser marker 2 is positioned with a high accuracy while a focal point is positioned. Then, the operation of the dot marking is initiated.

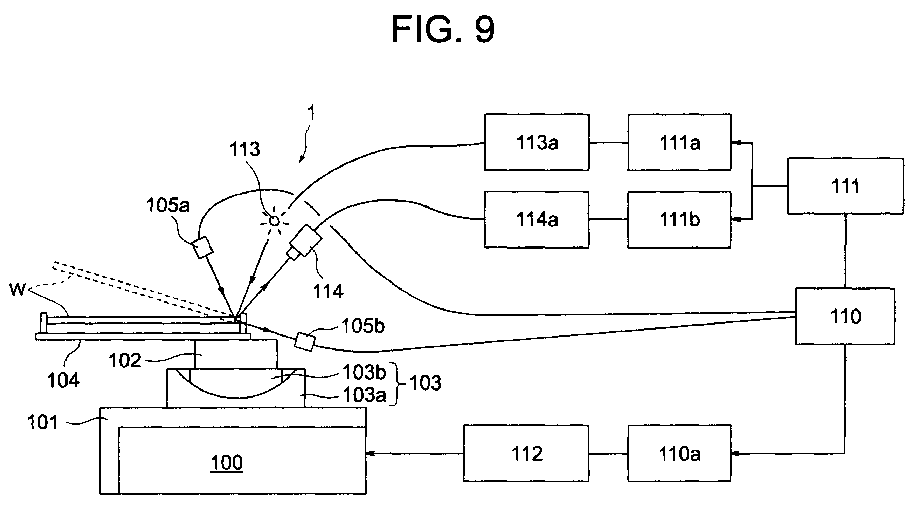

FIG. 9 is a block diagram showing a schematic arrangement of a mark reading apparatus 7 incorporated with the wafer positioning apparatus. The mark reading apparatus 1 according to the present embodiment comprises a mark reading apparatus disclosed in Japanese Patent Application No. 11-211302 by the applicant of the present invention incorporated with the flat surface detecting apparatus. A mark applied to the wafer W comprises a dot mark, which has a minute size and is generated by the laser beam as described above. The marking area comprises the flat surface 12b of the chamfer area 12 of the V notch portion 10 defined on the wafer W.

According to the embodiment shown in FIG. 9, the detecting apparatus for the flat surface 12b is substantially same as the detecting apparatus of the above described laser marker. In other words, as well as above described embodiment, the present embodiment does not record the detected data, the above respective control driven motors are driven by means of the main controlling unit 110 and the wafer W is positioned simultaneously with detection of the flat surface 12b.

The rotational table 102 is mounted on the rotational pedestal 103b, which fits to the guide groove 103a' of the fix pedestal 103a and rotates. The direct action stage 101 is controlled to rotate with respect to the recessed center O of the V notch portion 10 around a line x connecting the recessed center O and the wafer center O' by an unillustrated mechanism. The direct action stage 101 is also controlled to move around a line z orthogonaling to the surface of the wafer W through the recessed center O. Further, in addition to the controllable rotation of the wafer W, as well as the above embodiment, a structure to controllably move the direct action stage 101 in the three axes of the three axial coordinate system (x, y, z) is adopted.

On the other hand, a lighting source 113 of the dot mark reading unit is arranged such that it irradiates from diagonally upward to the flat surface 12b of the upper chamfer area 12, which is defined on the V notch portion 10 of the wafer W with a predetermined irradiating angle. A CCD camera 114 is arranged so as to orthogonal an optical axis OA to the flat surface 12b. In this case, it is necessary to arrange the light emitter 105a and the light receiver 105b of the detector 105 in a position such that they do not interfere with the lighting source 113 of the dot mark reading unit and the CCD camera 114.

A controllable movement of the direct action stage 101 in the three axial coordinate system comprising right and left direction (x axial direction), back and forth direction (y axial direction) and vertical direction (z axial direction) is carried out by driving a motor driver 112 based on a signal received from the main controlling unit 110 connected to an image processing unit 111 via a direct action stage control unit 110a. The lighting amount of the lighting source 113 or the like is controlled by controlling the lighting source 113 based on a signal from a lighting control unit 111a of the image processing unit 111. Further, a focal point of the CCD camera 114 or the like is also controlled by a camera control unit 114a receiving a signal from an image input unit 111b of the image processing unit 111.

According to the present embodiment, an optical axis of the CCD camera 114 is vertically directed to the flat surface 12b of the V notch portion which is the irradiated surface. The lighting source 113 is arranged diagonally upward with a required opposing angle to an intersecting point between the optical axis of the camera 114 and the flat surface 12b as a dot mark reading surface of the V notch portion. The inverse relation between the camera 114 and the lighting source 113 may be possible. According to the present embodiment, it is preferable that the light beam from the lighting source 113 is an irradiation of a natural light and an incoherent light other than a coherent light, as described above. However, a coherent light is also available. According to the present embodiment, the light received by the camera 114 is not a refection light flax having an even directional movement due to a parallel light but it is a diffused reflection light flax diffusely reflected from the irradiated surface within a predetermined area.

This relation between the lighting and the received light is different from the arrangement of the laser marker 2 with respect to the arrangement of the lighting source 113 and the camera 114, so that a high accuracy in positioning is not required. Therefore, the relation is advantageous because various arrangements can be set. Further, when the dot mark defined on the V notch portion 10 of the semiconductor wafer W has a prominent shape, most of the diffused reflections to be received by the camera 114 are generated on the dot mark surface when the dot mark and the irradiated surface on the vicinity of the dot mark are compared. For example, receiving the diffused reflection via an unillustrated converging lens, the luminance is larger than the luminance of the diffused reflection of the vicinity of the dot mark, so that the dot mark is reliably recognized.

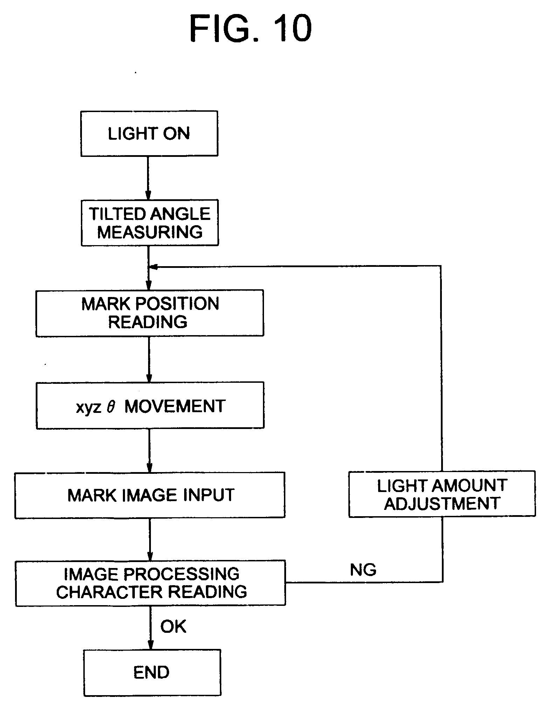

FIG. 10 shows a reading procedure of the dot mark according to the present embodiment. If a lighting power supply 113a turns on and the lighting source 113 is lighted, after above described measuring operation is effected to detect the flat surface 12b as a dot mark generation area, rotation and tilted rotation of the rotational table 102 are stopped and the reliable positioning of the wafer W is carried out. This positioning is effected by controllable movement of the motor driver 112 in the three axial coordinate system comprising right and left direction (x axial direction), back and forth direction (y axial direction) and vertical direction (z axial direction).

After this positioning is completed, the camera 114 reads the dot mark image and identifies an information content by image processing the image information. In this case, if the information content is not identified or the information content is not clear, the reading area in the inside of the V notch portion 10 is detected again and the above operation is again carried out. Then, reading of a dot mark written in a piece of the semiconductor wafer W is started again.

In this reading operation, the camera 114 is operated to read the image of the dot mark and the image information is digitally image processed to identify the information content. In this case, if the information content is not identified or the information content is not clear, the reading area in the inside of the V notch portion 10 is detected again and the above operation is again carried out.

According to the present embodiment, the emitted light beam is more than a spot light as described above and comprises a parallel light beam having a required irradiating area. In this state, as the light amount is changing, at first, a light image received by the light receiver 105b comprises a linear beam, but the width of the light image gradually increases and finally the light image received by the light receiver 105b takes a cross sectional shape of the light beam emitted from the light emitter 105a. At that time, the received light amount of the light electric detector 105b becomes maximum value. Further, keeping rotation of the unsurface to be detected makes the width of the light image gradually decreased and finally the light image becomes linear. When the received light amount of the light electric detector 105b becomes maximum, the light is reflected on the flat surface 12b and the light receiver 105b receives most of mirror reflections of the emitted light beam from the light emitter 105a. The camera 114 is arranged approximately on a normal line on the reflection surface.

According to the present embodiment, the light amount received by the light receiver 105b is converted to the electric amount to be transmitted to the main controlling unit 110. Then, by a visual check via a monitor or by detecting the maximum value of the light amount variation, it is detected to be the flat surface 12b. If the light with a cross section of a certain area is projected to receive its reflection and it is assumed that for example, the rotational axes of the flat surface 12b comprise two axes of the x axis and the z axis as described above, respective mirror reflection areas can be measured. Here, the respective mirror reflection areas are orthogonal to respective axis and they are directed in the two axial directions. Therefore, the flat surface 12b of the V notch portion 10 can be reliably detected.

Further, as long as the received light amount is kept at the maximum value, due to moving the direct action stage 101 in respective axial directions of x, y and z directions, it is possible to scan the dot mark writing area and to read all dot marks within the writing area. If the image cannot be read by the camera 114 even in the dot mark area, the above operation must be repeated to detect the flat surface 12b which is the writing area of the dot mark again.

Heretofore, the embodiments such that the light emitter and the light receiver are mounted to be fixed and the surface of the side to be detected is moved in various directions to detect the flat surface. However, the present invention is not limited to these embodiments. For example, securing the surface of the side to be detected, and the positions of the light emitter and the light receiver may be moved in various directions to detect the flat surface (not illustrated).

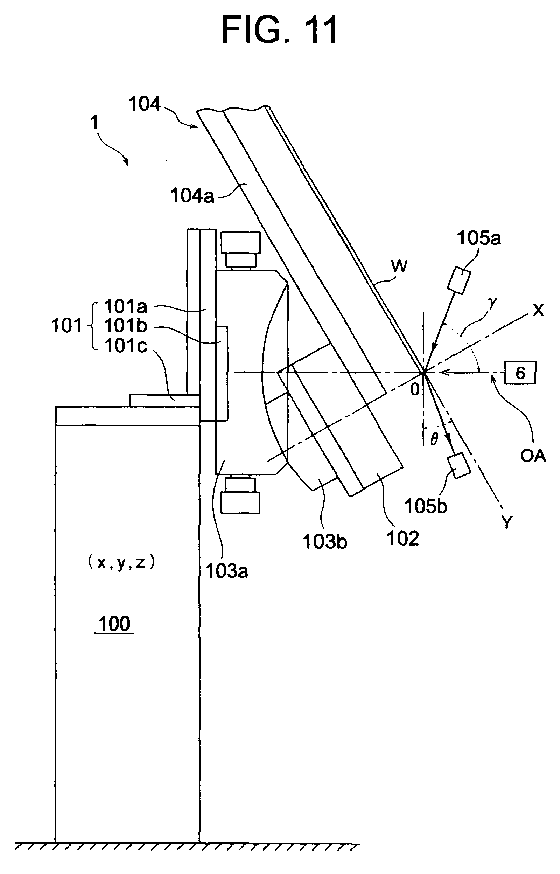

FIG. 11 shows main parts of a laser marker 1 provided with an apparatus for measuring the tilted angle of the flat surface 12b according to the third embodiment of the present invention. FIG. 11 is a side view of the tilted angle measuring apparatus. The same reference numerals are given to the members which are substantially same as the members in the first embodiment.

A supporting plate 104a of the wafer W is mounted on a fix pedestal 103a. The supporting plate 104a is controlled to move around a line Y connecting the center O and the wafer center O' with respect to the recessed bottom center O of the V notch portion 10 by an unillustrated operating mechanism. The supporting plate 104a is also controlled to rotate around a line X which passes through the center O and orthogonals to the surface of the wafer W. Further, the embodiment shown in FIG. 11 employs a configuration such that the supporting plate 104a is controlled to move in the three axial directions of three axial coordinate system (x, y, z) with respect to a bed 100 in addition to the controllable rotation of the wafer W. The controllable driving is carried out on the basis of a normal controlling mechanism in machine tools.

On the other hand, the lens unit 6 of the laser marker 1 is installed such that the optical axis OA is located on a line which approximately orthogonals to the flat surface 12b in the upper side chamfer defined on the V notch portion 10 of the wafer W. The light emitter 105a and the light receiver 105b of he tilted angle measuring apparatus of the present invention are installed such that respective optical axes cross each other to the intersecting point between the flat surface 12b and the optical axis OA of the laser marker 1. In this state, the arranging positions of the light emitter 105a and the light receiver 105b are located such that they do not interfere with the laser marker 1.

Also according to the present embodiment, the emitted light beam is more than a spot light as described above and comprises a parallel light beam having a required irradiating area When the light amount is changing, at first, a light image received by the light electric detector 105b comprises a linear beam as shown in FIG. 7, but the width of the light image gradually increases and finally the light image received by the light electric detector 105b takes a cross sectional shape of the light beam emitted from the light emitter 104a. At that time, the received light amount of the light electric detector 105b becomes maximum value. Further, keeping rotation of the flat surface 12b makes the width of the light image gradually decreased and finally the light image becomes linear. If the flat surface 12b has the rotation angle such that the received light amount of the light electric detector 105b becomes maximum, the light electric detector 105b receives the mirror reflections of the emitted light beam from the light emitter 104a. From a crossing angle between a natural line of the reflection surface and an extension line of the wafer W surface, a tilted angle of the flat surface 12b to the wafer surface, i.e., a tilted angle of the chamfer portion can be calculated.

According to the present embodiment, the light amount received by the light receiver 105b is converted to the electric amount to be transmitted to the main controlling unit 110. Then, by a visual check via a monitor, or the rotational angle of the flat surface 12b when the light amount variation reaches the maximum value, an incident angle $\gamma$ is calculated. With the incident angle $\gamma$, the angle made by the wafer surface and the flat surface 12b, i.e., a tilted angle $\theta$ is calculated. The light beam emitted having a cross section of a certain area is projected and its reflection is received and it is assumed that for example, the rotational axes of the flat surface 12b comprise two axes of the y axis and the z axis as described above, respective mirror reflection areas can be measured. Here, the respective mirror reflection areas are orthogonal to respective axis and they are directed in the two axial directions. Therefore, a tilted angle in the area, in which the flat surface 12b of the V notch portion 10 exist, can be reliably detected.

Thus, upon measuring the tilted angle $\theta$, the supporting plate 101 is controlled to move on the stage of the tree axial coordinate system (x, y, z) in the tree axial directions, so that the optical axis OA of the laser marker 1 is positioned on a natural line of the mirror reflection point to the marking area of the flat surface 12b. As described above, a focal point positioning is automatically carried out and the dot marking operation is initiated.

Further, the tilted angle measuring apparatus of the present invention may be used for a dot mark reading apparatus after marking as described above. It is preferable that the dot mark configuration to be generated on the dot mark generating surface is generated such that the reflection of the mark portion is scattered on a top of the dot mark upon irradiating a coherent light or an incoherent light to the surface of the dot mark. Such a dot mark protrudes upwardly from the dot mark generating surface as generated by the laser marker.

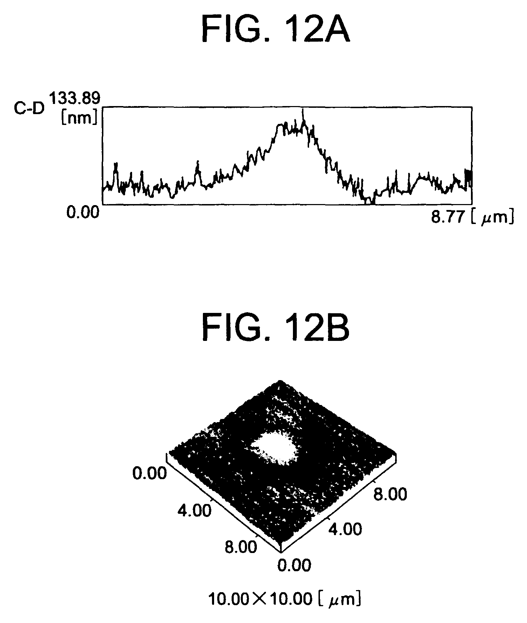

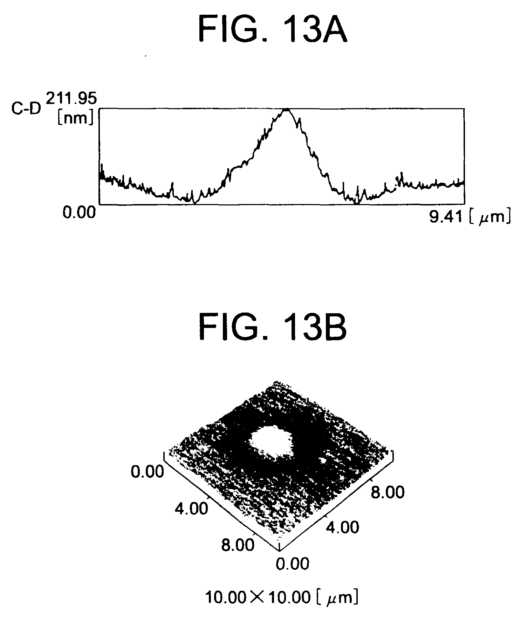

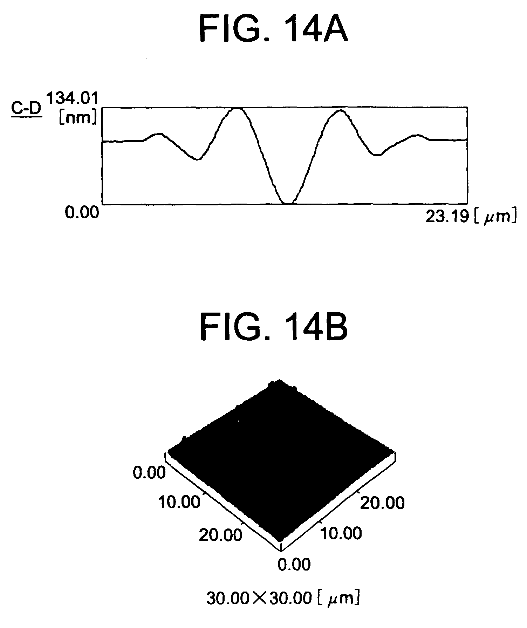

The above dot mark having a recessed central portion actually generated by the laser marker is compared with the dot mark having a bulged central portion with respect to an optical imaging received by the dot mark reading apparatus in which the tilted angle measuring apparatus is incorporated. FIGS. 12 and 13 show optical images obtained by picturizing minute dot marks with the bulged central portions by the dot mark reading apparatus from diagonally upward. FIG. 14B shows an optical image with respect to a minute dot mark with a dot figuration having a conventional recessed central portion and a bulged portion in a ring shape. From these optical images, it is appreciated that a large difference in clearness of the optical images is given due to the dot mark configuration.

The protruded dot mark has the size as follows: Namely, a width is 3.6 μm, a height ranges from 0.134 μm - 0.211 μm and each dot distance is 4.5 μm.

**Claims**

1.  A non contact detecting apparatus for detecting a flat surface area including:

    irradiating means (105a) for irradiating a light beam having a required cross sectional area on a detecting surface (12b, 13b);
    light receiving means (105b) for receiving a reflection of the irradiated light beam;
    measuring means for measuring received light variation of the reflection; and
    maximum light amount area detecting means for detecting the maximum light amount area, in which the measured light amount exceeds a predetermined light amount.

2.  A non contact detecting apparatus according to claim 1, including moving means for moving said measuring surface (12b, 13b), being characterized in that said moving means includes moving means (101 - 103) for moving said measuring surface (12b, 13b) to at least one direction among three axial directions (x, y, z) of three axial coordinate system, in which a predetermined point of said detecting surface (12b, 13b) is an origin (O), and rotational direction about the bending coordinate axis.

3.  A non contact detecting apparatus according to claim 1, including moving means for one or both of said irradiating means (105a) and said receiving means (105b).

4.  A laser marker for generating a dot mark on said flat surface due to irradiation of a laser beam and being provided with said non contact detecting apparatus of claim 1, being characterized in that said detecting surface (12b, 13b) includes a chamfer portion flat surface of a V notch portion (10) of a semiconductor wafer (W).

5.  A mark reading apparatus for reading the dot mark applied to said flat surface and being provided with said non contact detecting apparatus of claim 1, being characterized in that said detecting surface (12b, 13b) includes a chamfer portion flat surface of a V notch portion (10) of a semiconductor wafer (W).

6.  A non contact detecting method for detecting a flat surface area including:

    irradiating a light beam having a required cross sectional area on a measuring surface (12b, 13b);
    receiving a reflection of the irradiated light beam;
    measuring received light variation of the reflection; and
    detecting the maximum light amount area, in which the measured light amount exceeds a predetermined light amount.

7.  A tilted angle measuring apparatus for measuring a tilted angle (θ) of a tilted flat surface including:

    an optical system having a light emitter (105a) for irradiating a tilted flat surface as a measuring surface (12b, 13b) and a light receiver (105b) for receiving the reflection on said tilted flat surface;
    incident angle changing means (101 - 103)for relatively changing an incident angle (γ) of an optical axis of said light emitter (105a) to said measuring surface (12b, 13b);
    incident angle detecting means for detecting said Incident angle (γ) at the maximum receiving light by said light receiver (105b) when said incident angle (γ) is changing; and
    calculating means for calculating a tilted angle (θ) of said tilted flat surface from said incident angle (γ) at the maximum receiving light detected by said incident angle detecting means.

**8.** A tilted angle measuring apparatus according to claim 7, being characterized in that said incident angle detecting means has a rotation driving system for rotating said detecting surface (12b, 13b) around a line on said detecting surface (12b, 13b) which passes through an intersecting point between an optical axis of said light emitter (105a) and said detecting surface (12b, 13b).

**9.** A tilted angle measuring apparatus according to claim 7, being characterized in that said incident angle detecting means has a rotation driving system for rotating said light emitter (105a) in a plane including said light emitter (105a) and said light receiver (105b), without changing an intersecting point between an optical axis of said light emitter (105a) and said measuring surface (12b, 13b).

**10.** A laser marker for generating a dot mark on said flat surface due to irradiation of a laser beam and being provided with said tilted angle measuring apparatus of claim 7, being characterized in that said measuring surface (12b, 13b) includes a chamfer portion flat surface of a V notch portion (10) of a semiconductor wafer (W).

**11.** A mark reading apparatus for reading the dot mark applied to said flat surface and being provided with said tilted angle measuring apparatus of claim 7, being characterized in that said measuring surface (12b, 13b) includes a chamfer portion flat surface of a V notch portion (10) of a semiconductor wafer (W).

# FIG. 1

# FIG. 2

# FIG. 3

# FIG. 4

# FIG. 5

# FIG. 6

# FIG. 7

CURRENT (I)

INCIDENT ANGLE ($\gamma$)

# FIG. 8A

SENSOR
OUTPUT

ROTATION
ANGLE

# FIG. 8B

SENSOR
OUTPUT

$\delta$

ROTATION
ANGLE

FIG. 9

# FIG. 10

```
┌─────────────────┐
│    LIGHT ON     │
└─────────────────┘
         │
         ▼
┌─────────────────┐
│  TILTED ANGLE   │
│   MEASURING     │
└─────────────────┘
         │
         ▼
┌─────────────────┐
│  MARK POSITION  │
│    READING      │
└─────────────────┘
         │
         ▼
┌─────────────────┐
│  xyz θ MOVEMENT │
└─────────────────┘
         │
         ▼
┌─────────────────┐          ┌─────────────────┐
│ MARK IMAGE INPUT│          │  LIGHT AMOUNT   │
└─────────────────┘          │   ADJUSTMENT    │
         │                   └─────────────────┘
         ▼
┌─────────────────┐    NG
│ IMAGE PROCESSING│──────────►
│ CHARACTER READING│
└─────────────────┘
         │ OK
         ▼
┌─────────────────┐
│      END        │
└─────────────────┘
```

# FIG. 11

# FIG. 12A

C-D $\frac{133.89}{[nm]}$

0.00                    8.77 [ μm]

# FIG. 12B

0.00

4.00                    8.00

8.00                    4.00

0.00

10.00×10.00 [ μm]

# FIG. 13A

C-D 211.95 [nm]

0.00                                              9.41 [ μm ]

# FIG. 13B

0.00

4.00

8.00

8.00

4.00

0.00

10.00 × 10.00 [ μm ]

# FIG. 14A

C-D 134.01
[nm]

0.00                                              23.19 [ μm]

# FIG. 14B

0.00
10.00          20.00
20.00          10.00
0.00

30.00✕30.00 [ μm]